Europäisches Patentamt

European Patent Office

Office européen des brevets

(11) Numéro de publication: **0 219 366**
**A1**

(12) ## DEMANDE DE BREVET EUROPEEN

(21) Numéro de dépôt: **86401881.7**

(51) Int. Cl.⁴: **H 03 B 19/14**

(22) Date de dépôt: **27.08.86**

(30) Priorité: **06.09.85 FR 8513241**
**06.09.85 FR 8513242**

(43) Date de publication de la demande:
**22.04.87 Bulletin 87/17**

(84) Etats contractants désignés:
**BE DE GB IT NL**

(71) Demandeur: **ENERTEC**
**12 Place des Etats Unis**
**F-92120 Montrouge(FR)**

(72) Inventeur: **Marcoux, Jean**
**2, Allée Antoine Watteau**
**F-78190 Montigny le Bretonneux(FR)**

(72) Inventeur: **Allamando, Etienne André**
**9, rue des Ecoles**
**F-59199 Bruille St. Amand(FR)**

(72) Inventeur: **Constant, Eugène**
**39, Avenue de Vieux Chateau**
**F-59655 Villeneuve d'Asq(FR)**

(74) Mandataire: **Bentz, Jean-Paul**
**GIERS SCHLUMBERGER Service BREVETS 12, place des Etats-Unis**
**F-92124 Montrouge Cedex(FR)**

(54) Générateur harmonique de haut rang.

(57) Utilisation d'un transistor à effet de champ (FET) (1) dans un circuit hyperfréquence, notamment d'un FET du type AsGa comme multiplicateur de fréquence.

L'utilisation de fréquences d'entrée comprises entre 50MHz et 2,5 GHz et de circuits à sortie accordée (4) permettent d'engendrer des composantes harmoniques de haut rang.

Un FET à "double grille" peut être employé comme échantillonneur de signal dans la gamme des hautes fréquences.

FIG.1

EP 0 219 366 A1

## GENERATEUR HARMONIQUE DE HAUT RANG

La présente invention concerne un dispositif applicable aux hyperfréquences pour produire des harmoniques d'un signal d'entrée, comprenant : un transistor à effet de champ à semi-conducteurs III-V, doté d'au moins trois bornes dénommées source, drain et grille; des organes d'entrée pour appliquer le signal d'entrée sur la grille avec une tension suffisante pour induire un fonctionnement non linéaire du transistor; et des organes de sortie pour recueillir, sur une borne du transistor, un signal de sortie lié à l'une au moins des harmoniques du signal d'entrée.

Un dispositif de ce type est connu, et par exemple décrit dans la revue "IEEE transactions on microwave theory and techniques", volume MTT-27, nr 5, mai 1979, ou volume MTT-30, nr 6, Juin 1982.

Ces deux articles révèlent l'aptitude des transistors à effet de champ, en particulier des transistors à arseniure de gallium (GaAs), à constituer des multiplicateurs de fréquence de rang relativement bas, par exemple de rang 2 ou 3.

De façon générale, ces deux articles s'inscrivent dans la tendance actuelle à utiliser spécifiquement les semi-conducteurs III-V, encore relativement peu répandus, pour le traitement des signaux dont la fréquence est trop élevée pour être adéquatement traités par la mise en oeuvre de techniques ou de technologies plus classiques.

En particulier les deux articles mentionnés ci-dessus, appartenant au domaine de la recherche fondamentale, relatent des expériences de doublage ou de triplage de fréquence de signaux d'entrée de fréquence relativement élevée, au moins égale à 4 GHz.

Dans ce contexte de connaissances, la présente invention s'analyse comme une application industrielle basée sur une découverte. Plus précisément, l'invention repose sur la découverte de l'aptitude des transistors à effet de champ à semi-conducteurs III-V à constituer des générateurs harmoniques à large bande et de rang très élevé, par exemple jusqu'à l'ordre 200.

Non seulement cette propriété des transistors à effet de champ n'a pas été observée au cours des expériences citées plus haut, mais elle n'était en outre ni observable ni même sollicitée.

En effet, cette propriété n'était pas observable dans la mesure où, les signaux d'entrée utilisés étant de fréquence relativement élevée, les signaux de sortie qui auraient correspondu à une multiplication de fréquence de haut rang se seraient situés au delà du domaine de fréquences actuellement susceptible de faire l'objet d'observations sûres. D'autre part, les organes de sortie de ces dispositifs antérieurs utilisés pour conduire ces expériences, étant spécifiquement adaptés à la transmission de signaux de sortie dans une bande étroite centrée sur la fréquence qui devait être observée dans le cas de doublage ou de triplage de fréquence, ne pouvaient être adaptés à la transmission de signaux de sortie à large bande ou correspondant à des multiplications de fréquence nettement supérieures à 2 ou 3.

Par ailleurs, cette propriété des transistors à effet de champ de pouvoir constituer des générateurs harmoniques de haut rang ne peut être considérée comme ayant véritablement été sollicitée dans les expériences antérieures relatées dans les articles cités ci-dessus. Il apparaît en effet, comme le montre le premier de ces articles, que les pertes de puissance, entre le signal d'entrée et le signal de sortie à fréquence multiple, augmentent de façon sensible lorsque le rang de multiplication augmente, même lorsqu'il ne passe que de 2 à 3.

Comme par ailleurs ces pertes augmentent de façon importante avec la fréquence du signal d'entrée, et comme la tension du signal d'entrée qui était appliqué dans les expériences antérieures restait assez modeste, correspondant par exemple à une puissance maximale de 15 dBm, ces expériences ne pouvaient conduire à la production d'un signal de sortie correspondant à un rang élevé de multiplication de fréquence et présentant une puissance suffisante pour être physiquement utilisable ou distingué du bruit.

Au contraire, dans le dispositif de l'invention le signal d'entrée est appliqué avec une fréquence qui, pour le domaine concerné des hyperfréquences, est relativement basse, et les organes de sortie sont adaptés à recueillir un signal correspondant à une multiplication de fréquence de rang relativement élevé.

Plus précisément, ce dispositif est essentiellement caractérisé en ce que le signal d'entrée a une fréquence comprise entre 50 MHz et 2.5 GHz, et en ce que les organes de sortie sont adaptés à recueillir, en tant que signal de sortie, un signal lié à l'une au moins des harmoniques, de rang au moins égal à 10, du signal d'entrée.

Par ailleurs le signal d'entrée est de préférence appliqué avec une tension comprise entre 3 et 5 fois la tension de pincement du canal conducteur du transistor.

Plusieurs modes de réalisation de ce dispositif s'avèrent très avantageux.

Par exemple, les organes d'entrée peuvent comprendre un oscillateur formé d'un résonateur bouclé sur un élément actif, le dispositif constituant ainsi un générateur hyperfréquence à large spectre permettant la production de signaux hyperfréquence dont la fréquence est contrôlée de façon rigoureuse.

En effet, la fréquence des signaux de sortie est définie par celle des signaux d'entrée et la fréquence de ces derniers, relativement basse, peut être contrôlée de façon relativement aisée.

En particulier, ces organes d'entrée peuvent comprendre un oscillateur à quartz délivrant, en tant que signal d'entrée, un signal à la fréquence de résonance du quartz.

Ce dispositif peut être ainsi utilisé par exemple comme générateur de peigne de fréquences. Si la fréquence du signal d'entrée est comprise entre 800 MHz et 2 GHz, et par exemple voisine de 1 GHz, les raies du peigne de fréquences, relativement peu nombreuses mais bien espacées, forment un spectre d'amplitude assez homogène.

Si la fréquence du signal d'entrée est inférieure à 200 MHz, et de préférence comprise entre 50 et 150 MHz, les raies du peigne de fréquences sont très nombreuses et très serrées.

Dans ces deux cas, les organes de sortie peuvent comprendre un filtre passe-bande, éventuellement réglable, pour sélectionner une ou plusieurs raies, le dispositif étant alors utilisable comme un générateur hyperfréquence à fréquence déterminée, éventuellement réglable.

Le transistor à effet de champ utilisé est de préférence un transistor à deux grilles dont la première est proche de la source et la seconde proche du drain, et le signal d'entrée est de préférence alors appliqué sur la première grille. Si le signal de sortie est recueilli sur le drain, la seconde grille est de préférence, au moins vis-à-vis d'un signal à la fréquence du signal de sortie, connectée à la masse.

Cependant le signal de sortie peut également être recueilli sur la seconde grille. L'amplitude du spectre de fréquence du signal de sortie est plus homogène, sur un domaine de fréquence déterminé, dans le cas où ce signal est recueilli sur la seconde grille, que dans le cas où ce signal est récupéré sur le drain.

En outre, le signal recueilli sur la seconde grille est formé d'impulsions de très courte durée, par exemple susceptible de se limiter à quelques dizaines de picosecondes.

Dans une autre application utilisant un transistor à deux grilles, les organes d'entrée appliquent le signal d'entrée sur l'une des grilles et un signal à traiter sur l'autre grille; le dispositif constitue alors un mélangeur large bande avec échantillonnage sur harmoniques, produisant en tant que signal de sortie un signal résultant du mélange du signal à traiter avec les harmoniques du signal d'entrée.

De préférence, dans cette application, le signal à traiter est appliqué sur la grille proche de la source, et le signal d'entrée sur la grille proche du drain.

D'autres caractéristiques et avantages de l'invention ressortiront de la description qui en est faite ci-après, à titre indicatif et nullement limitatif, en référence aux dessins annexés parmi lesquels :

- la figure 1 est un schéma d'un dispositif conforme à l'invention, utilisable en générateur hyperfréquence;

- la figure 2 est un schéma d'un dispositif conforme à l'invention, constituant un mélangeur large bande ou une tête d'échantillonnage;

- la figure 3 représente le spectre de fréquence en peigne d'un signal à large bande produit selon l'invention;

- la figure 4 représente un autre spectre de fréquence en peigne d'un signal également produit selon l'invention.

- la figure 5 représente le spectre de fréquence d'une raie à 10 GHz produite et sélectionnée par un dispositif conforme à l'invention ;

- les figures 6A et 6B représentent les évolutions en fonction du temps de l'amplitude de signaux de sortie produits conformément à l'invention ;

- la figure 7 représente une partie du spectre de fréquence d'un signal de sortie obtenu par mélange à large bande, conformément à l'invention.

L'invention concerne l'application aux hyperfréquences des transistors à effet de champ à semi-conducteurs III.V, de préférence des transistors sur arséniure de gallium (AsGa), et à grille(s) à contact Schottky (MESFET).

Les transistors de ce type sont actuellement connus et par exemple commercialisés sous la marque "AVANTEK" avec la référence AVANTEK AT 11 200, ou sous la marque "NEC" avec la référence NE 46 300, ou NEC 720.

Ces transistors comportent au moins trois bornes, à savoir une source, un drain et au moins un grille, la source et le drain étant disposés aux extrémités d'un canal allongé et la ou les grille(s) étant en contact avec le canal en des emplacements intermédiaires entre la source et le drain.

Traditionnellement, la grille la plus proche de la source est dite "première grille", et l'autre "seconde grille".

Pour son fonctionnement, le transistor à effet de champ est polarisé d'une part entre la source et le drain et d'autre part entre la source et chacune des grilles.

En outre, un signal d'entrée, superposé à la tension de polarisation, est appliqué sur l'une des grilles.

L'homme de l'art sait que pour un certain mode de polarisation, dit de classe A, et pour une tension relativement faible du signal d'entrée, le transistor adopte un fonctionnement linéaire, c'est-à-dire que les variations du signal de sortie susceptible d'être récupéré sur le drain sont proportionnelles aux variations du signal d'entrée.

L'homme de l'art sait aussi que pour d'autres modes de polarisation de la grille du transistor, dits de classe B ou de classe C, et pour une tension plus élevée du signal d'entrée, le transistor adopte un fonctionnement non linéaire; dans ce cas, le signal de sortie est distordu par rapport au signal d'entrée; en particulier le transistor peut ne conduire que pendant des intervalles de temps inférieurs à la moitié de la période du signal d'entrée.

Dans le dispositif de l'invention, le transistor à effet de champ est utilisé en régime fortement non linéaire, avec des modes de polarisation de classe B ou C.

Par exemple, pour un transistor ayant une tension de pincement, c'est-à-dire une tension au-dessus de laquelle le canal du transistor cesse d'être conducteur, de l'ordre de -1,2V, la grille (ou la première grille) du transistor est polarisée entre -1V et -4V.

Ce signal d'entrée est, selon l'invention, appliquée avec une tension de l'ordre de trois à cinq fois la tension de pincement du canal conducteur, par exemple 5 Volts en valeur maximale pour une tension de pincement de -1,2V.

En terme de puissance, cela signifie que ce signal d'entrée est appliqué, par exemple pour des transistors du type de ceux précédemment mentionnés, avec une puissance de l'ordre de 25 dBm (0 dBm correspond à 1 milliwatt et les impédances caractéristiques sont fixées à 50 Ohms); par ailleurs, la tension drain-source est de l'ordre de 6 à 7 V et le courant de drain est de l'ordre de 80 mA.

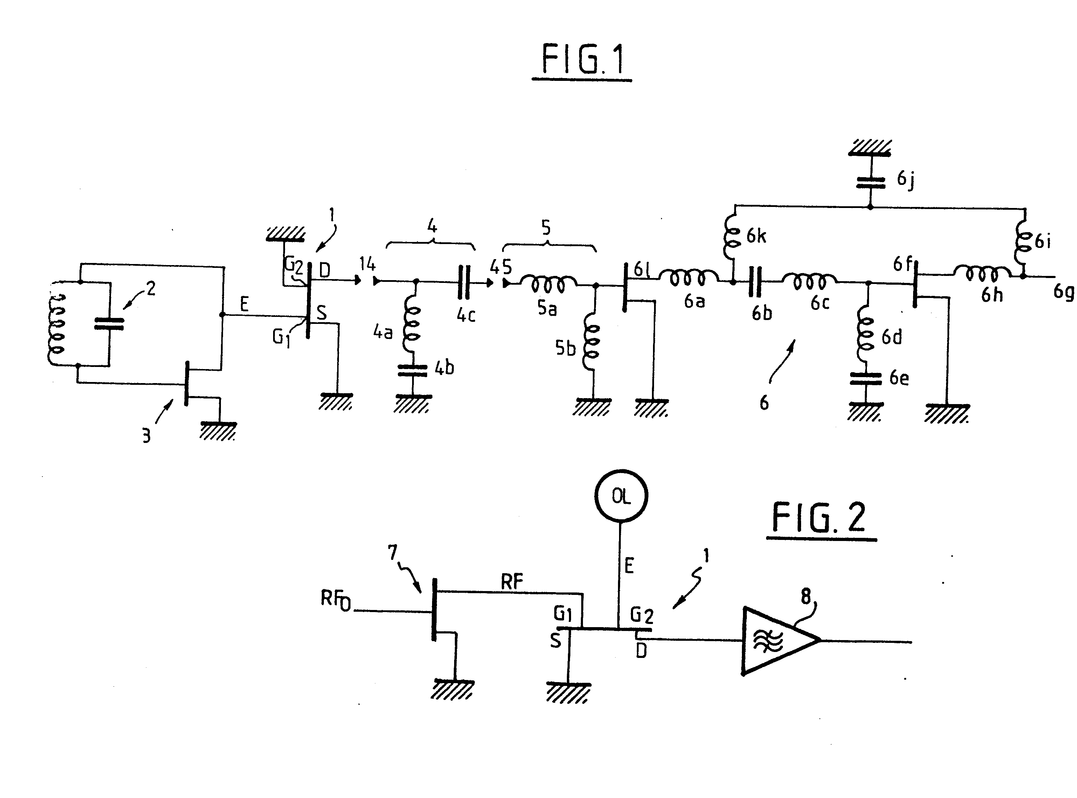

La figure 1 représente un montage réalisant un générateur hyperfréquence.

Le transistor à effet de champ 1 peut être du type monogrille, mais peut, de façon plus avantageuse, être du type bigrille comme représenté; le transistor comporte alors une première grille $G_1$ proche de la source S et une seconde grille $G_2$ proche du drain D.

Le signal d'entrée E, appliqué sur la grille $G_1$, a une fréquence relativement basse, comprise entre 50 MHz et 2.5 GHz.

Dans un premier type d'application, ce signal E est par exemple le signal de sortie d'un oscillateur, formé d'un résonateur 2, par exemple un quartz ou une ligne à retard acoustique, bouclé sur un élément actif 3, par exemple un transistor à effet de champ monogrille de type NE 244 fabriqué par la Société NEC. Dans ce cas, la fréquence du signal d'entrée E est par exemple inférieure à 200 MHz, de préférence comprise entre 50 et 150 MHz et typiquement voisine de 100 MHz si ce signal est produit à partir d'un quartz.

La fréquence du signal E peut être modifiée, par changement du résonateur 2 ou de sa fréquence propre. Le signal E ainsi fourni au transistor 1 présente une grande pureté spectrale et une fréquence susceptible d'être contrôlée de façon très rigoureuse par des techniques classiques.

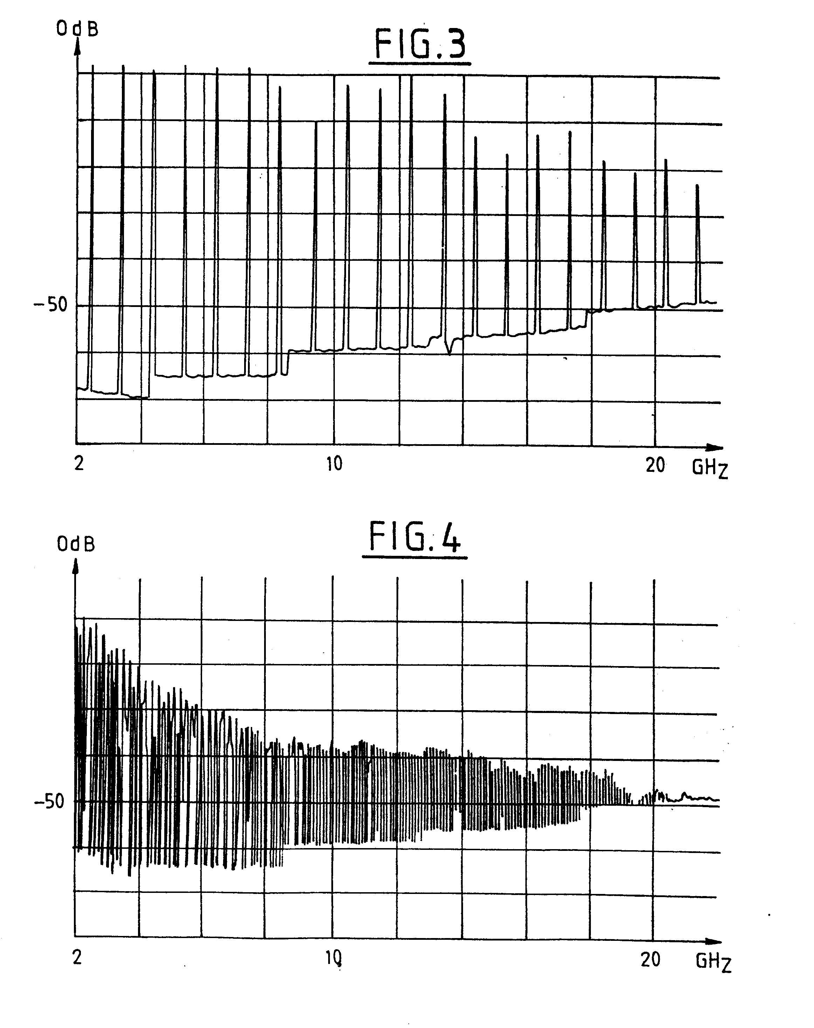

Le signal de sortie, recueilli par exemple sur le drain D, présente alors un spectre de fréquences très riche et à bande large, tel que représenté sur la figure 4, sur laquelle les fréquences en gigahertz sont portées en abscisse et les amplitudes relatives en décibels sont portées en ordonnée.

L'une des raies de ce spectre, correspondant à une multiplication de fréquence de haut rang, par exemple au moins égal à 10, ou même supérieur à 50 et typiquement de l'ordre de 100, peut être sélectionnée au moyen d'organes de sortie appropriés adoptant sur la figure 1 la forme d'un filtre 4, d'un adaptateur d'impédance 5, et d'un amplificateur sélectif 6, opérant ensemble un filtrage passe-bande très sélectif.

A partir d'un signal d'entrée E de 100 MHz à 25 dBm, conduisant à l'apparition sur le drain D du transistor 1 du signal de sortie à large bande représenté sur la figure 4, il est ainsi possible d'obtenir, par exemple, à la sortie 6g de l'amplificateur sélectif 6, un signal de sortie filtré à

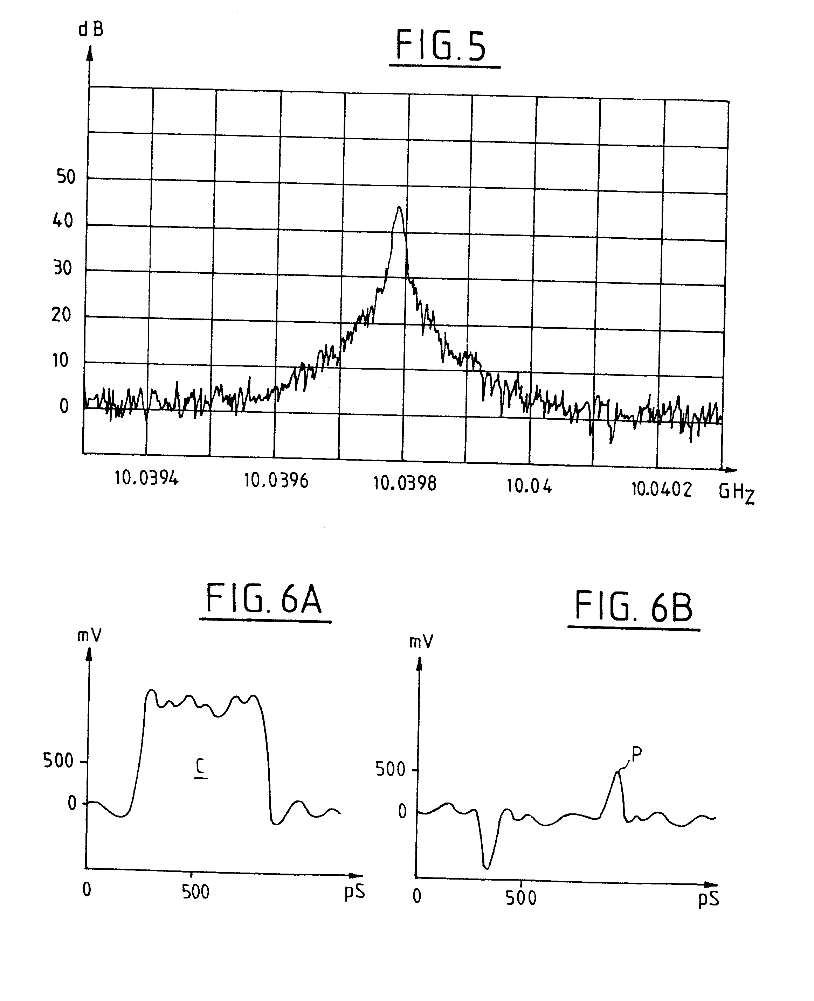

10 GHz, tel que représenté sur la figure 5, sur laquelle les fréquences en gigahertz sont portées en abscisse et les amplitudes relatives en décibels sont portées en ordonnée.

Dans cette application, le transistor 1 peut être un transistor à effet de champ monogrille, par exemple un transistor NE 463 fabriqué par la Société NEC, ou un transistor bigrille, par exemple un transistor AVANTEK 11200 fabriqué par la Société AVANTEK. Dans ce dernier cas, la seconde grille G2 est, vis-à-vis des signaux hyperfréquences, reliée à la masse. Cette seconde grille est en outre soumise à une polarisation positive continue de l'ordre de 1 à 2 Volts avec un courant limité à quelques milliampères. Ceci peut être obtenu, comme cela est bien connu de l'Homme de l'Art, en reliant la grille G2 à la masse à travers un condensateur dont la borne directement reliée à la grille est raccordée à un potentiel positif.

Le filtre 4, relié au drain D par un couplage 14, comporte une self-inductance 4a de 1,8 nH et un condensateur 4b de 0,4 pF reliés en série à la masse pour un signal hyperfréquence, ainsi qu'un condensateur de sortie 4c de 0,56 pF.

L'adaptateur d'impédance 5 relié au filtre 4 par un couplage 45, comporte deux inductances 5a, 5b de 0,16 nH et 0,43 nH respectivement, dont la seconde est reliée à la masse pour un signal hyperfréquence, et dont le point commun est relié à la grille d'un transistor monogrille à effet de champ 61; ce transistor, qui constitue l'organe d'entrée de l'amplificateur sélectif 6, consiste par exemple en un transistor de référence NE 388 fabriqué par la Société NEC.

L'amplificateur sélectif 6, accordé sur 10 GHz dans l'exemple présenté, comporte en outre des organes de filtrage, comprenant en série une self inductance 6a de 1,2nH, un condensateur 6b de 1,65 pF, et une autre self inductance 6c de 0,65 nH.

La sortie de la self inductance 6c est, pour un signal hyperfréquence, reliée d'une part à la masse à travers une self inductance 6d de 0,54 nH et un condensateur 6e de 8,4 pF, et d'autre part à la grille d'un transistor à effet de champ monogrille 6f constituant le second élément actif de l'amplificateur, par exemple identique au transistor 61.

Le drain du transistor 6f est relié à la sortie 6g du montage par une self inductance 6h de 0,63 nH.

La sortie 6g est en outre, pour un signal hyperfréquence, reliée à la masse à travers une self inductance 6i de 0,18nH et un condensateur 6j de 0,7 pF. Une inductance 6k de 0,6 nH relie la borne commune aux composants 6a et 6b à la borne commune aux composants 6i et 6j.

Le signal disponible à la sortie 6g peut par exemple être appliqué à un amplificateur à grain variable (non représenté), utilisant un transistor bigrille AVANTEK AT 11200.

Le dispositif de la figure 1 peut également, et de façon très avantageuse, faire l'objet d'une réalisation monolithique, permettant encore d'élargir la bande de fréquence des signaux produits.

Dans une autre forme d'application, très voisine, le signal d'entrée E, appliqué au transistor 1 peut avoir une fréquence comprise entre 800 MHz et 2 GHz, et de préférence voisine de 1 GHz.

Le signal de sortie du transistor 1, qui est recueilli par exemple sur le drain D, et qui présente toujours l'allure d'un peigne de raies à large bande, est composé de raies espacées, telles que représentées sur la figure 3, comparable à la figure 4.

Dans cette forme d'application, comme dans la précédente, le transistor 1 est de préférence un transistor bigrille et, si le signal de sortie du transistor 1 est recueilli sur le drain D de ce dernier, la seconde grille $G_2$ est de préférence polarisée positivement et, pour un signal hyperfréquence, reliée à la masse.

Il est cependant possible, dans ces deux formes d'application du dispositif, de recueillir le signal de sortie du transistor 1 sur la grille $G_2$ de ce dernier.

Par rapport au signal recueilli sur le drain, dont les figures 3 et 4 donnent deux exemples, le signal recueilli sur la seconde grille du transistor présente deux différences essentielles, dont l'une se manifeste dans le domaine fréquentiel et l'autre dans le domaine temporel.

Pour ce qui concerne la différence dans le domaine fréquentiel, le signal recueilli sur la seconde grille $G_2$ est plus homogène en fréquence que le signal recueilli sur le drain D ; plus précisément, le rapport d'amplitude entre le signal de sortie correspondant à une multiplication de rang x quelconque à l'amplitude du signal d'entrée varie, pour x variant sur une plage déterminée, entre des valeurs extrêmes plus proches l'une de l'autre lorsque le signal de sortie est recueilli sur la seconde grille $G_2$ que lorsqu'il est recueilli sur le drain D.

Dans le domaine temporel, la différence est illustrée par les figures 6A et 6B, sur lesquelles le temps est porté en picosecondes en abscisse et l'amplitude en millivolts en ordonnée.

Le signal de sortie recueilli sur le drain D (figures 6A) est un signal formé de créneaux tels que C, dont la durée est voisine de la moitié de l'inverse de la fréquence du signal d'entrée.

Au contraire, le signal de sortie recueilli sur la seconde grille $G_2$ (figure 6B) du transistor 1 est formé de pics, tels que P, dont l'évolution correspond à la dérivée en fonction du temps des flancs des créneaux C, et dont la durée peut être très faible, par exemple de l'ordre de quelques dizaines de picosecondes.

La figure 2 illustre l'application du dispositif de l'invention au mélange de signaux et plus précisément au mélange d'un signal à traiter avec les harmoniques d'un signal d'entrée.

Le signal RF à traiter, par exemple obtenu par amplification dans un transistor 7 à effet de champ d'un signal initial $RF_o$, est appliqué à la première grille $G_1$ du transistor 1.

Le signal d'entrée E, par exemple constitué par le signal de sortie à 1 GHz d'un oscillateur local OL, est appliqué sur la seconde grille $G_2$ du transistor 1 avec une puissance suffisante, par exemple 25 dBm, pour que ce transistor adopte un régime de fonctionnement fortement non linéaire.

Le signal susceptible d'être recueilli sur le drain D du transistor 1 est un signal à large bande, s'étalant par exemple sur une bande de 20 GHz, résultant du mélange du signal RF à traiter avec les harmoniques successives du signal d'entrée E.

Le signal de sortie du transistor 1 peut être filtré au moyen d'un filtre relativement étroit, par exemple un filtre passe-bas ou passe-bande 8, qui fournit à sa sortie un signal résultant du mélange du signal à traiter RF avec au moins une harmonique de haut rang du signal d'entrée E.

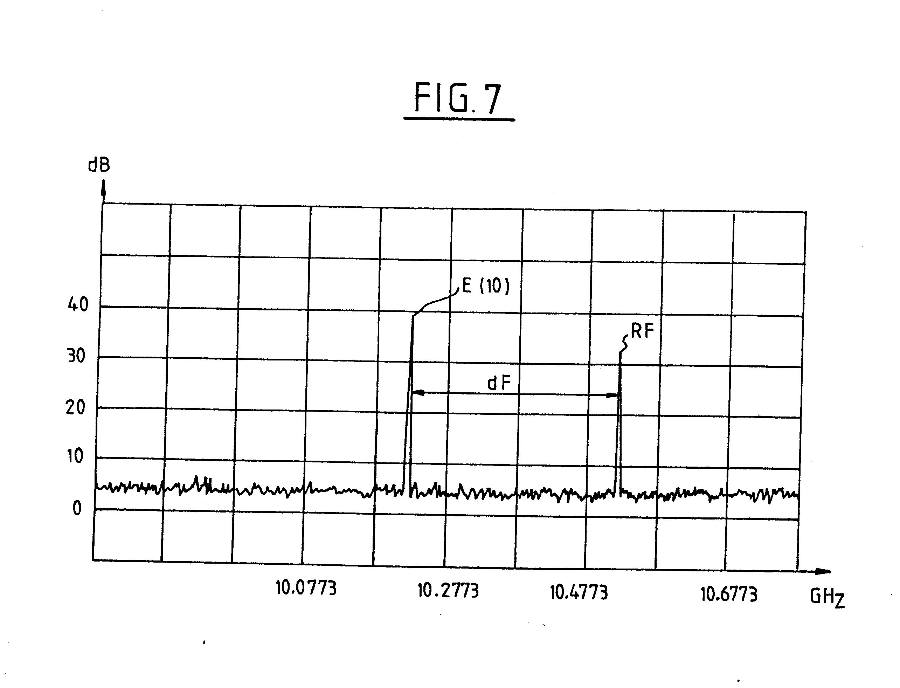

La figure 7, sur laquelle les fréquences en gigahertz sont portées en abscisse, et les amplitudes relatives en décibels sont portées en ordonnée, représente une partie du spectre, au voisinage de 10 GHz, du signal de sortie recueilli sur le drain D du transistor 1 recevant sur la première grille un signal RF voisin de 10,5 GHz et sur la seconde grille un signal d'entrée E de l'ordre de 1,02 GHz.

La figure 7 montre très clairement la présence simultanée du signal RF et de la dixième harmonique E(10) du signal d'entrée E, séparée du signal RF d'un écart de fréquence dF de l'ordre de 300 MHz.

## REVENDICATIONS

1. Dispositif applicable aux hyperfréquences pour produire des harmoniques d'un signal d'entrée, comprenant : un transistor à effet de champ à semi-conducteurs III-V, doté d'au moins trois bornes dénommées source, drain et grille; des organes d'entrée pour appliquer le signal d'entrée sur la grille avec une tension suffisante pour induire un fonctionnement non linéaire du transistor; et des organes de sortie pour recueillir, sur une borne du transistor, un signal de sortie lié à l'une au moins des harmoniques du signal d'entrée, caractérisé en ce que ledit signal d'entrée a une fréquence comprise entre 50MHz et 2.5.GHz, et en ce que lesdits organes de sortie sont adaptés à recueillir, en tant que signal de sortie, un signal lié à l'une au moins des harmoniques, de rang au moins égal à 10, du signal d'entrée.

2. Dispositif suivant la revendication 1, caractérisé en ce que lesdits organes d'entrée comprennent un oscillateur essentiellement formé d'un résonateur associé à un élément actif.

3. Dispositif suivant la revendication 1 ou 2, caractérisé en ce que lesdits organes d'entrée comprennent un oscillateur à quartz délivrant, en tant que signal d'entrée, un signal à la fréquence de résonance du quartz.

4. Dispositif suivant la revendication 2 ou 3, caractérisé en ce que lesdits organes de sortie comprennent un filtre passe-bande.

5. Dispositif suivant l'une quelconque des revendications précédentes, caractérisé en ce que ledit transistor

0219366

comporte deux grilles dont la première est proche de la source et la seconde proche du drain, le signal d'entrée étant appliqué sur la première grille.

6. Dispositif suivant la revendication 5, caractérisé en ce que le signal de sortie est recueilli sur le drain et en ce que la seconde grille est, au moins vis-à-vis d'un signal à la fréquence du signal de sortie, connectée à la masse.

7. Dispositif suivant la revendication 5, caractérisé en ce que le signal de sortie est recueilli sur la seconde grille.

8. Dispositif suivant la revendication 1, caractérisé en ce que ledit transistor comporte deux grilles, et en ce que les organes d'entrée appliquent le signal d'entrée sur l'une des grilles et un signal à traiter sur l'autre grille, ce dispositif constituant un mélangeur large bande avec échantillonnage sur harmoniques, produisant en tant que signal de sortie un signal résultant du mélange du signal à traiter avec les harmoniques du signal d'entrée.

9. Dispositif suivant la revendication 8, caractérisé en ce que le signal à traiter est appliqué sur la grille proche de la source et le signal d'entrée sur la grille proche du drain.

10. Dispositif suivant l'une quelconque des revendications précédentes, caractérisé en ce que le signal d'entrée est appliqué avec une tension comprise entre trois et cinq fois la tension de pincement du canal conducteur du transistor.

0219366

11. Application du dispositif suivant l'une quelconque des revendications 1 à 7 à la production de signaux hyperfréquence de fréquence contrôlée.

12. Application du dispositif suivant la revendication 7 à la production d'impulsions de très courte durée.

# FIG.1

# FIG.2

1/4

0219366

## FIG.3

## FIG.4

## FIG.5

## FIG. 6A

## FIG. 6B

FIG. 7

4 / 4

0219366

**Office européen des brevets**

**RAPPORT DE RECHERCHE EUROPEENNE**

0219366

Numero de la demande

EP  86 40 1881

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A,D | IEEE TRANSACTIONS ON MICROWAVE THEORY AND TECHNIQUES, vol. MTT-27, no. 5, mai 1979, pages 411-415, IEEE, New York, US; P.T. CHEN et al.: "Performance of a dual-gate GaAs MESFET as a frequency multiplier at Ku-band" * Page 412, colonne de gauche, lignes 1-19; page 413, colonne de gauche, ligne 9 - page 414, colonne de droite, ligne 11; figures 1,6-9 * | 1,2,4-6,11 | H 03 B 19/14 |
| A | --- <br> IEEE TRANSACTIONS ON MICROWAVE THEORY AND TECHNIQUES, vol. MTT-29, no. 3, mars 1981, pages 261-263, IEEE, New York, US; M.S. GUPTA et al.: "Performance and design of microwave FET harmonic generators" * En entier * <br><br> ---     -/- | 1,2,4,11 | |

DOMAINES TECHNIQUES RECHERCHES (Int. Cl.4)

H 03 B
H 03 D

Le present rapport de recherche a été etabli pour toutes les revendications

| Lieu de la recherche | Date d'achèvement de la recherche | Examinateur |
|---|---|---|
| LA HAYE | 18-11-1986 | BALBINOT H. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503 03 82

0219366

Office européen
des brevets

**RAPPORT DE RECHERCHE EUROPEENNE**

Numero de la demande

EP 86 40 1881

Page 2

| Catégorie | Citation du document avec indication. en cas de besoin. des parties pertinentes | Revendication concernée | CLASSEMENT DE LA DEMANDE (Int. Cl.4) |
|---|---|---|---|
| A | CONFERENCE PROCEEDINGS 13TH EUROPEAN MICROWAVE CONFERENCE, 5th-8th septembre 1983, Nürnberg, DE, pages 252-257; Microwave Exhibitions and Publishers Ltd., Turnbridge Wells, Kent, GB; T. SHIMA et al.: "Circuit design and FM noise characteristics of 20/30 GHz GaAs MESFET mulitplier chains" * Page 252, ligne 29 - page 253, ligne 35; figures 3-9 * | 1,4,11 | |
| A | US-A-2 926 312 (F.A. BRAND et al.) * Colonne 3, ligne 27 - colonne 4, ligne 2; figure 1 * | 1,11 | |
| A | L'ONDE ELECTRIQUE, vol. 65, no. 1, janvier/février 1985, pages 23-26, Paris, FR; A.E. FUSTE et al.: "Mélangeur sous harmonique à MESTEC AsGa" * En entier * ---     -/- | 8 | DOMAINES TECHNIQUES RECHERCHES (Int. Cl.4) |

Le present rapport de recherche a été établi pour toutes les revendications

| Lieu de la recherche | Date d'achèvement de la recherche | Examinateur |
|---|---|---|
| LA HAYE | 18-11-1986 | BALBINOT H. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur. mais publié à la date de dépôt ou après cette date
D : cité dans la demande
L : cité pour d'autres raisons

& : membre de la même famille. document correspondant

OEB Form 1503 03 82

**Office européen des brevets**

# RAPPORT DE RECHERCHE EUROPEENNE

Numero de la demande

EP 86 40 1881

| | DOCUMENTS CONSIDERES COMME PERTINENTS | | Page 3 |
|---|---|---|---|
| Catégorie | Citation du document avec indication. en cas de besoin. des parties pertinentes | Revendication concernée | CLASSEMENT DE LA DEMANDE (Int. Cl.4) |
| A | CONFERENCE PROCEEDINGS 7TH EUROPEAN MICROWAVE CONFERENCE, 5th-8th septembre 1977, Copenhague, pages 101-104, Microwave Exhibitions and Publishers Ltd., Sevenoaks, Kent GB; S.C. CRIPPS et al.: "An experimental evaluation of X-band mixers using dual-gate GaAs MESFETS" * Page 101, ligne 18 - page 102, ligne 28; figures 3-8 * | 8,9 | |
| | --- | | |
| A | IEEE TRANSACTIONS ON MICROWAVE THEORY AND TECHNIQUES, vol. MTT-33, no. 2, février 1985, pages 105-110, IEEE, New York, US; T. SUGIURA et al.: "12-GHz-band GaAs dual-gate MESFET monolithic mixers" * Page 105, colonne de gauche, lignes 8-11; page 105, colonne de droite, lignes 17-44; page 108, colonne de gauche, ligne 14 - colonne de droite, ligne 30; figures 1,9-13 * | 8,9 | DOMAINES TECHNIQUES RECHERCHES (Int. Cl.4) |
| | ----- | | |

Le present rapport de recherche a été établi pour toutes les revendications

| Lieu de la recherche | Date d'achevement de la recherche | Examinateur |
|---|---|---|
| LA HAYE | 18-11-1986 | BALBINOT H. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur. mais publié à la date de dépôt ou après cette date
D : cité dans la demande
L : cité pour d'autres raisons

& : membre de la même famille. document correspondant

OEB Form 1503 03 82